# EUROPEAN PATENT APPLICATION

(11) **EP 3 422 407 A1**
(43) Date of publication of application: **02.01.2019**
(21) Application number: 17892506.1
(22) Date of filing: 22.01.2017
(51) Int. Cl.: H01L 23/544, G06K 9/00

(54) **SEMICONDUCTOR CHIP MODULE AND MANUFACTURING METHOD FOR ENHANCING VISUAL EFFECT OF PATTERN LAYER**

(71) Applicant: Shenzhen Goodix Technology Co., Ltd., Shenzhen, Guangdong 518045 (CN)
(72) Inventor: ZHU, Jianyu, Shenzhen Guangdong 518045 (CN); HOU, Lyu, Shenzhen Guangdong 518045 (CN)
(74) Representative: J A Kemp
(86) International application number: PCT/CN2017/072040
(87) International publication number: WO 2018/133058

(57) **Abstract**

A semiconductor chip module and a method for enhancing visual effects of a pattern layer, which relate to the field of semiconductor technology. The semiconductor chip module includes: a flexible printed circuit (1, 10), a sensor layer (2, 20), a color layer (3, 30), a pattern layer (4, 40), and a covering layer (5, 50); where the sensor layer (2, 20) is disposed above the flexible printed circuit (1, 10), and the sensor layer (2, 20) includes at least one sensor; the color layer (3, 30) is disposed above the sensor layer (2, 20); the covering layer (5, 50) is disposed above the color layer (3, 30); the pattern layer (4, 40) is covered by the covering layer (5, 50) or the color layer (3, 30). The pattern layer of the semiconductor chip module in the embodiments of the present application is colored firmly and has various display effects.

## Description

### TECHNICAL FIELD

The technical solutions disclosed in the present application relate to the field of semiconductor technology and, in particular, to a semiconductor chip module and a method for enhancing visual effects of a pattern layer.

### BACKGROUND

At present, many manufacturers of the semiconductor chip module usually make pattern layers (for example, trademarks) with identification functions on the produced semiconductor chip modules so as to distinguish their products from those of other manufacturers on the market.

### SUMMARY

The technical solutions disclosed in the present application can solve at least the following technical problems: the pattern layer on the semiconductor chip module is not solidly colored and has a single effect.

One or more embodiments of the present application disclose a semiconductor chip module, including a flexible printed circuit (FPC), a sensor layer, a color layer, a pattern layer, and a covering layer; where the sensor layer is disposed above the flexible printed circuit, and the sensor layer includes at least one sensor; the color layer is disposed above the sensor layer; the covering layer is disposed above the color layer; and the pattern layer is covered by the covering layer or the color layer.

In one or more embodiments of the present application, a thickness of the pattern layer is less than 20um; and a material of the pattern layer is ink.

In one or more embodiments of the present application, the sensor is a fingerprint recognition sensor.

In one or more embodiments of the present application, the covering layer is a hardened layer having a transparent effect; and a material of the hardened layer is paint.

In one or more embodiments of the present application, the covering layer is a cover plate having a transparent effect; and a material of the cover plate is glass.

In one or more embodiments of the present application, the semiconductor chip module further includes: an adhesive layer used for adhering the sensor layer and the color layer; and the adhesive layer is an adhesive film or glue.

One or more embodiments of the present application disclose a method for enhancing visual effects of a pattern layer, including: coating a color layer on a sensor layer; screen printing a pattern layer on the color layer; and coating a hardened layer on the pattern layer.

In one or more embodiments of the present application, before screen printing the pattern layer on the color layer, the method further includes baking the color layer; before coating the hardened layer on the pattern layer, the method further includes baking the pattern layer.

One or more embodiments of the present application also disclose a method for enhancing visual effects of a pattern layer, including: screen printing a pattern layer on a covering layer; coating a color layer on the pattern layer; and adhering the cover plate, at a side having the color layer, to the sensor layer.

In one or more embodiments of the present application, before coating the color layer on the pattern layer, the method further includes baking the pattern layer; before adhering the cover plate, at a side having the color layer, to the sensor layer, the method further includes baking the color layer.

In one or more embodiments of the present application, the cover plate is adhered, at a side having the color layer, to the sensor layer using an adhesive film or glue.

Compared with the prior art, the technical solutions disclosed in the present application mainly have the following beneficial effects:
In the embodiments of the present application, the pattern layer of the semiconductor chip module is covered by the covering layer, and the covering layer has a transparent effect. Since the color of the color layer is distinguished from that of the pattern layer and the covering layer has the transparent effect, the pattern layer can be clearly displayed and the visual effects of the pattern layer are enhanced. In addition, the covering layer can protect the color layer and the pattern layer, and can play a role in enhancing the visual effects to some extent. For the semiconductor chip module obtained through a method for enhancing visual effects of a pattern layer, the pattern layer is colored firmly and the display effect is varied. In addition, the method for enhancing the visual effects of the pattern layer has a simple process, which does not conflict with the existing process and has good compatibility in terms of production inputs.

### BRIEF DESCRIPTION OF DRAWINGS

In order to explain the technical solutions of the embodiments of the present application more clearly, accompanying drawings used in the embodiments will be briefly described below. Obviously, the drawings in the following description are merely some embodiments of the present application. For those of ordinary skill in the art, other drawings may also be obtained based on these drawings without any creative effort.
FIG. 1 is a schematic structural diagram of a semiconductor chip module according to an embodiment of the present application; and
FIG. 2 is a schematic structural diagram of a semiconductor chip module according to another embodiment of the present application.

1-flexible printed circuit; 2-sensor layer; 3-color layer; 4-pattern layer; 5-covering layer; 10-flexible printed circuit; 20-sensor layer; 30-color layer; 40-pattern layer; 50- covering layer; 60-adhesive layer.

### DESCRIPTION OF EMBODIMENTS

In order to make the present application easier to understand, a more comprehensive description of this application will be given below with reference to the accompanying drawings. The preferred embodiments of the present application are given in the accompanying drawings. However, the present application can be implemented in many different forms and is not limited to the embodiments described herein. Rather, these embodiments are provided so that this disclosure will be understood thoroughly and comprehensively.

Unless otherwise defined, all technical and scientific terms used herein have the same meanings as commonly understood by one of ordinary skill in the art to which this application belongs. The terminologies used herein in the description of this application are for the purpose of describing particular embodiments only and are not intended to limit the present application.

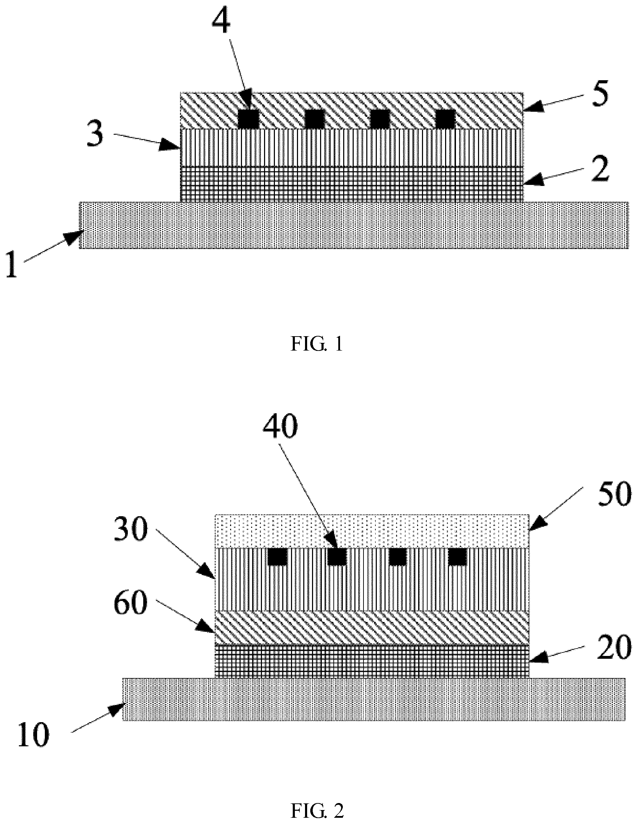

Reference may be made to FIG. 1 which is a schematic structural diagram of a semiconductor chip module according to an embodiment of the present application. The semiconductor chip module includes a flexible printed circuit 1, a sensor layer 2, a color layer 3, a pattern layer 4 and a covering layer 5. The color layer 3 is distinguished from the pattern layer 4 in terms of color, and the color of both the color layer 3 and the pattern layer 4 is set as required.

The sensor layer 2 is disposed above the flexible printed circuit 1, and the sensor layer 2 includes at least one sensor. The color layer 3 is disposed above the sensor layer 2. The covering layer 5 is disposed above the color layer 3. The pattern layer 4 is covered by the covering layer 5.

In some embodiments of the present application, a thickness of the pattern layer 4 is less than 20 um. A material of the pattern layer 4 is ink.

In some embodiments of the present application, the sensor is a fingerprint recognition sensor.

In some embodiments of the present application, the covering layer 5 is a hardened layer having a transparent effect. A material of the hardened layer is paint.

For the semiconductor chip module in the above embodiments, the pattern layer 4 is covered by the covering layer 5, and the covering layer 5 is a hardened layer having a transparent effect. Since the color of the layer 3 is distinguished from that of the pattern layer 4 and the hardened layer has the transparent effect, the pattern layer 4 can be clearly displayed and the visual effects of the pattern layer 4 are enhanced. In addition, the hardened layer can protect the color layer 3 and the pattern layer 4, and play a role in enhancing the visual effects to some extent.

Another embodiment of the present application discloses a method for enhancing visual effects of a pattern layer, which is applied to a production process of the above-mentioned semiconductor chip module. The method includes: coating a color layer 3 on a sensor layer 2; screen printing a pattern layer 4 on the color layer 3; coating a hardened layer 5 on the pattern layer 4.

In one or more embodiments of the present application, before screen printing the pattern layer 4 on the color layer 3, the method further includes baking the color layer 3; before coating the hardened layer 5 on the pattern layer 4, the method further includes baking the pattern layer 4. The color layer 3 and the pattern layer 4 are cured and adhered as quickly as possible by baking the color layer 3 and the pattern layer 4.

The method for enhancing the visual effects of the pattern layer in the embodiments described above is favorable for forming, on the semiconductor chip module, a pattern layer 4 (for example, a trademark) that is firmly colored and has various display effects. In addition, the method for enhancing the visual effects of the pattern layer in the above embodiments has a simple process, which does not conflict with the existing process and has good compatibility in terms of production inputs.

Reference may be made to FIG. 2 which is a schematic structural diagram of a semiconductor chip module according to another embodiment of the present application. The semiconductor chip module includes: a flexible printed circuit 10, a sensor layer 20, a color layer 30, a pattern layer 40, a covering layer 50, and an adhesive layer 60. The color of the color layer 30 is distinguished from that of the pattern layer 40. The color of both the color layer 30 and the pattern layer 40 are set as required.

The sensor layer 20 is disposed above the flexible printed circuit 10, and the sensor layer 20 includes at least one sensor. The adhesive layer 60 is located between the color layer 30 and the sensor layer 20. The covering layer 50 is disposed above the color layer 30. The pattern layer 40 is located between the color layer 30 and the covering layer 50.

In some embodiments of the present application, the covering layer 50 is a cover plate having a transparent effect. A material of the cover plate is glass.

In some embodiments of the present application, the adhesive layer 60 adhering the sensor layer 20 and the color layer 30 is an adhesive film or glue.

For the semiconductor chip module in the above embodiments, the pattern layer 40 is located between the color layer 30 and the covering layer 50, and the covering layer 50 is a cover plate having a transparent effect. Since the color of the color layer 30 is distinguished from that of the pattern layer 40 and the cover plate has the transparent effect, the pattern layer 40 can be clearly displayed and the visual effects of the pattern layer 40 are enhanced. In addition, the cover plate can protect the color layer 30 and the pattern layer 40, and plays a role in enhancing the visual effects to some extent.

Another embodiment of the present application discloses a method for enhancing visual effects of a pattern layer, which is applied to a production process of the above-described semiconductor chip module. The method includes: screen printing a pattern layer 40 on a cover plate; coating a color layer 30 on the pattern layer 40; adhering the cover plate, at a side having the color layer 30, to the sensor layer 20.

In one or more embodiments of the present application, before coating the color layer 30 on the pattern layer 40, the method further includes baking the pattern layer 40; before adhering the cover plate, at a side having the color layer 40, to the sensor layer 20, the method further includes baking the color layer 30. The pattern layer 40 and the color layer 30 can be cured and adhered as quickly as possible by baking the pattern layer 40 and the color layer 30.

In one or more embodiments of the present application, the cover plate is adhered, at a side having the color layer 30, to the sensor layer 40 using an adhesive film or glue.

For the semiconductor chip module obtained through a method for enhancing visual effects of a pattern layer, the pattern layer 40 is colored firmly and the display effect is varied. In addition, the method for enhancing the visual effects of the pattern layer has a simple process, which does not conflict with the existing process and has good compatibility in terms of production inputs.

Finally, it should be noted that the above embodiments are only used to illustrate the technical solutions of the present application, rather than limiting the present application. Although the present application has been described in detail with reference to the foregoing embodiments, it will be understood by those skilled in the art that the technical solutions described in the foregoing embodiments may still be modified, or some of the technical features may be equivalently replaced. These modifications or substitutions do not make essence of corresponding technical solutions depart from the spirit and scope of the technical solutions of the embodiments of the present application.

## Claims

1. A semiconductor chip module, comprising:
a flexible printed circuit, a sensor layer, a color layer, a pattern layer and a covering layer; wherein the sensor layer is disposed above the flexible printed circuit, and the sensor layer comprises at least one sensor;
the color layer is disposed above the sensor layer;
the covering layer is disposed above the color layer; and
the pattern layer is covered by the covering layer or the color layer.

2. The semiconductor chip module according to claim 1, wherein a thickness of the pattern layer is less than 20um; and
a material of the pattern layer is ink.

3. The semiconductor chip module according to claim 1, wherein the sensor is a fingerprint recognition sensor.

4. The semiconductor chip module according to any one of claims 1 to 3, wherein the covering layer is a hardened layer having a transparent effect; and
a material of the hardened layer is paint.

5. The semiconductor chip module according to any one of claims 1 to 3, wherein the covering layer is a cover plate having a transparent effect; and
a material of the cover plate is glass.

6. The semiconductor chip module according to claim 5, wherein the semiconductor chip module further comprises:
an adhesive layer used for adhering the sensor layer and the color layer; and
the adhesive layer is an adhesive film or glue.

7. A method for enhancing visual effects of a pattern layer, comprising:
coating a color layer on a sensor layer;
screen printing a pattern layer on the color layer; and
coating a hardened layer on the pattern layer.

8. The method for enhancing the visual effects of the pattern layer according to claim 7, wherein, before screen printing the pattern layer on the color layer, the method further comprises baking the color layer;
before coating the hardened layer on the pattern layer, the method further comprises baking the pattern layer.

9. A method for enhancing visual effects of a pattern layer, comprising:
screen printing a pattern layer on a cover plate;
coating a color layer on the pattern layer; and
adhering the cover plate, at a side having the color layer, to the sensor layer.

10. The method for enhancing the visual effects of the pattern layer according to claim 9, wherein, before coating the color layer on the pattern layer, the method further comprises baking the pattern layer;
before adhering the cover plate, at a side having the color layer, to the sensor layer, the method further comprises baking the color layer.

11. The method for enhancing the visual effects of the pattern layer according to claim 9 or 10, wherein the cover plate is adhered, at a side having the color layer, to the sensor layer using an adhesive film or glue.
